# EUROPEAN PATENT SPECIFICATION

(11) **EP 3 299 498 B1**
(45) Date of publication and mention of the grant of the patent: **19.02.2020**
(21) Application number: 17807991.9
(22) Date of filing: 31.05.2017
(51) Int. Cl.: C30B 13/10, C30B 13/24, C30B 11/10, C30B 29/06, C30B 11/00

(54) **SINGLE CRYSTAL PRODUCING DEVICE**
EINKRISTALLZÜCHTUNGSVORRICHTUNG
DISPOSITIF DE PRODUCTION DE MONOCRISTAL

(30) Priority: 28.07.2016 JP 2016148306
(43) Date of publication of application: 28.03.2018
(73) Proprietor: Crystal Systems Corporation, Hokuto-shi, Yamanashi 408-0044 (JP)
(72) Inventor: SHINDO, Isamu, Hokuto-shi Yamanashi 408-0041 (JP)
(74) Representative: Michalski Hüttermann & Partner Patentanwälte mbB
(86) International application number: PCT/JP2017/020228
(87) International publication number: WO 2018/020821

(56) References cited:
- EP-A1- 2 246 461
- WO-A1-2009/081811
- JP-A- H05 286 791
- JP-A- H06 345 583
- JP-A- H06 345 583
- JP-A- 2008 081 398
- JP-U- S5 915 056
- US-A- 5 108 720
- US-A- 5 367 981

## Description

### TECHNICAL FIELD

The present invention relates to an infrared intensive heating-type single-crystal production equipment which produces a single crystal by heating and melting a raw material by irradiation with an infrared ray and subsequently solidifying the raw material on a seed crystal or the like.

### BACKGROUND ART

So-called single-crystal materials in which atoms constituting the subject substance are regularly arranged are being used in many fields such as the semiconductor industry and the optical communication industry, playing an important role. As a method of producing such a single crystal, a so-called "melt method", in which a powder raw material is melted to separate its atoms and then allowed to solidify slowly, thereby a single crystal properly solidified to have a prescribed arrangement is produced, is known.

In addition, for example, a vapor-phase method which utilizes a reaction of gasses to produce a single crystal, and a flux method in which a single crystal is produced by melting a raw material in a flux and then allowing the thus melted raw material to precipitate as a solid are also known.

Thereamong, the melt method is known to be capable of producing a large single-crystal material with the highest efficiency.

As such a melt method, for example, a pulling method in which a melt is retained in an appropriate crucible and a seed crystal immersed therein is pull upward while being grown in thickness, a floating-zone melting method in which a portion of a raw material molded in a rod shape is melted by local heating and then solidified to produce a single crystal, and the Bridgman method in which a large single crystal is produced by melting a raw material in a crucible and then slowly solidifying the thus melted raw material as is from a lower part in the upward direction are known.

Among these production methods, in the pulling method and the Bridgman method, since a melt is retained in a container such as a crucible, the crucible material may be fused into the melt and the resulting single crystal may thereby be contaminated with a portion of the crucible material.

When a dopant is added to a raw material melt, it is known that the concentration of the dopant will be different at a certain ratio between the melt and a single crystal solidified therefrom. This is referred to as "distribution", and the ratio between the concentration in a melt and that in a crystal solidified from the melt is referred to as "distribution coefficient".

In the industrial utilization of a grown single crystal, such as the use as a solar cell substrate, phosphorus or boron is added as a dopant. The optimum concentration of each dopant is already known, and the single crystal is desired to have the optimum dopant concentration in its entirety.

However, in the above-described pulling method and Bridgman method, since a raw material is entirely melted first and then allowed to slowly solidify from an upper part or a lower part, the resulting grown single crystal has a dopant concentration defined by the above-described distribution coefficient and thus never has a constant concentration as a whole, showing a tendency that the concentration is initially low and gradually increases.

On the other hand, in a so-called infrared floating-zone melting method (also referred to as "infrared FZ method") where a raw material is processed into a rod form, melted by irradiating an infrared ray to a lower part thereof and then solidified, since the melting and solidification are continuously carried out with the raw material rod itself retaining its melt, there is no contamination from a crucible material or the like, so that a high-purity single crystal can be produced.

Further, this infrared FZ method is an ideal production method since the melting and solidification of a raw material are simultaneously and continuously carried out and thus, when a raw material in which a dopant is uniformly added is used, the resulting grown single crystal also has a uniform dopant concentration at the steady state condition.

However, such an infrared FZ method can only produce single crystals having a diameter of 30 mm or so at best, and such single crystals are mainly used as elements for research and development since they are not suitable for industrial applications where a large single crystal is required.

The reason why the infrared FZ method cannot produce a large single crystal is because it is difficult to form a large melt required for the production of a large single crystal. In other words, being capable of forming a melt by irradiation with an infrared ray means that the infrared ray is absorbed and converted into heat. Accordingly, since the infrared ray continues to be absorbed while passing through the melt, the amount of the infrared ray that can reach a deep part gradually decreases.

Further, in the infrared FZ method, a system of irradiating an infrared ray from the horizontal direction is employed and, in this system, since the temperature decreases as the amount of the infrared ray declines toward the center at the interface between a melt being formed and a solid therebelow, the resulting single crystal tends to have a convex shape with respect to the melt.

In such a case, the melt is likely to drip down on the outer part of the growing single crystal. Therefore, it is extremely difficult to produce such a large single crystal of larger than 30 mm in a diameter as described above.

Thus, an inclined irradiation-type infrared FZ method where an infrared is irradiated from obliquely above to a lower part was developed by the present inventor. In this inclined irradiation-type infrared FZ method, the melt formed by melting a raw material naturally flows down to a lower part due to gravity and sits on a seed crystal placed below.

When the seed crystal below has a flat upper surface, the melt sitting thereon is maintained by surface tension and, since this theoretically enables to stably retain the melt on the seed crystal even if the seed crystal has a large diameter, there will be no limitation on the diameter of a growable single crystal. Therefore, if melting of the raw material and solidification of a single crystal below the resulting melt could be actually maintained in a stable state at the same time, it would be possible to produce a large single crystal (for example, Patent Document 1) .

Until now, attempts have been made to produce a silicon single crystal by the inclined irradiation-type infrared FZ method, and it is already possible to produce a large single crystal that reaches a diameter of about 150 mm.

This is a remarkable progress considering that the diameter of a silicon single crystal that could be produced by a conventional horizontal irradiation-type infrared FZ method was 30 mm or so. Moreover, in a conventional pulling method, it is required to use a quartz crucible and a large amount of this quartz component is incorporated into the resulting single crystal; therefore, due to an exsolution phenomenon attributed thereto, the product performance is largely deteriorated.

However, in the inclined irradiation-type infrared FZ method, since such a defect is not introduced, a high-purity and high-quality single crystal can be produced, and there is a growing expectation for a further increase in the size of such a single crystal.

In the production of a larger single crystal by the inclined irradiation-type infrared FZ method, however, the following problems have been revealed as well.

That is, the production of a large raw material rod used for producing a large single crystal is a troublesome problem. A large single crystal can be produced using a small raw material rod; however, in this case, for example, in order to produce a single crystal of the same length using a raw material rod having a half the diameter of the crystal, it is necessary either to use a raw material rod having a four-fold length, or to continue the production of the single crystal while changing four raw material rods one after another. In order to use a long raw material rod in this manner, the size of the single-crystal production equipment has to be increased.

Meanwhile, when using raw material rods having the same length but a half the diameter so as to avoid an increase in the size of the single-crystal production equipment, it is necessary to discontinue the production in the middle and change the raw material rods one after another.

Such operations of changing the raw material rods lead to the generation of joints in the growing single crystal, which is inconvenient since a variety of defects are likely to be introduced to these joints.

Moreover, when a large raw material rod is used for the production of a large single crystal, since the amount of energy (dose of infrared ray) required for melting the large raw material rod is extremely large, a large infrared generator and a large power supply equipment necessary for operating the infrared generator are required.

In the previous scenes of producing a single crystal by an infrared FZ method, other than the above-described methods of producing a large single crystal, a method used to be considered sufficient for the research and development applications as long as the method can produce a high-quality product even if it is a fine single crystal of about 5 to 10 mm in diameter.

In a common production method, after molding a powder raw material into a round rod shape and sintering the resultant under appropriate conditions to increase its density, the thus obtained raw material rod is melted by irradiating an infrared ray to the lower end and then allowed to solidify as a single crystal on a seed crystal set on the lower side, thereby a round rod-shape single crystal is produced.

In order to produce a high-quality single crystal by this method, it is important that the melting of the raw material and the solidification of a single crystal be continuously carried out in a stable manner. Nevertheless, it is extremely difficult to achieve stable melting depending on the raw material and, consequently, the state of the thus formed melt changes every moment, leading to variations in the composition of the resulting single crystal or formation of a polycrystal.

For example, in the production of a single crystal of YBa₂Cu₃O₇ known as a high-temperature superconducting substance, when an infrared ray is irradiated to a raw material rod obtained by molding a powder of this composition so as to melt the raw material rod, partial melting of the raw material rod occurs and the bismuth and barium components having a large specific gravity exhibit a strong tendency of separating from the copper component having a small specific gravity, making it difficult to form a stable melt and thus to produce a high-quality single crystal.

It was found that, however, in such a case, a high-quality single crystal can be stably produced not by using a raw material rod obtained by molding a powder raw material into a round rod shape, but by supplying the raw material as is in the powder form and then melting it by irradiation with an infrared ray and solidifying the resultant as a single crystal.

### RELATED ART DOCUMENT

The purpose of JP H06 345583 is to obtain a high-quality single crystal with easy control even from a compd. having a non-stoichiometric solid soln. region by supplying optional crushed material and crushed raw material to the melt zone formed on a seed crystal in a specified ratio. A heating furnace is constituted so that the focus of one of spheroidal mirrors 1 and 2 is aligned, and the reflecting surface of the mirror is plated with gold. Halogen lamps 3 and 4 are arranged close to the other focuses F1 and F2 of the mirrors 1 and 2, and a solvent part 5 is provided at the common focus . A platinum plate 8 having a minute hole is horizontally placed thereon, and an alumina tube 9 is arranged thereabove. A YIG is fixed to a rotating shaft 6 as a seed crystal, and a pellet is placed thereon; The voltage of the halogen lamp is increased and the shaft 6 is raised when the pellet is liquefied, and the liq. is brought into contact with the plate 8. When a melt zone is formed between the plate and seed crystal, the raw powder is supplied on the plate through the tube 9 to grow a crystal.

US5 367 981 A presents an apparatus for manufacturing crystals through a floating zone method which includes: structure for forming a heat-melt zone so as to be held at an upper portion of a solid crystal; a barrier enclosure having an opening a lower end portion and provided in the vicinity of an upper surface of the heat-melt zone; structure for supplying a raw material granular crystal into the barrier enclosure; and structure for moving the solid crystal and the heat-melt zone forming structure relative to each other to thereby bring about crystal growth, wherein the barrier enclosure has a bottom surface being flat or inclined toward the center of the barrier enclosure, and wherein the opening is constituted by at least one hole formed in the bottom surface of the barrier enclosure.

EP 2 246 461 A1 provides a floating zone melting apparatus in which a sample rod especially having a large diameter can be stably melted with a certainty and the crystal being grown can retain a flat shape at the interface of the solid phase and the liquid phase, whereby a single crystal having a large diameter can be grown. [Problem] It is an object to provide a floating zone melting apparatus of the infrared concentration heating type in which a sample is set in a sample chamber made of a transparent quartz tube, an atmospheric gas is introduced into the sample chamber, infrared rays emitted from a plurality of infrared ray irradiation means are converged to the sample to heat and melt the sample in this state, thereby obtaining a melt, and the melt is solidified on a seed crystal to grow a single crystal. The plurality of infrared ray irradiation means comprise a plurality of infrared ray irradiation means of the downward irradiation type that emit an infrared ray downward from an oblique upper direction and a plurality of infrared ray irradiation means of the upward irradiation type that emit an infrared ray upward from an oblique lower direction.

### PATENT DOCUMENT

Patent Document 1: Japanese Patent NO. 5279727

### SUMMARY OF THE INVENTION

### PROBLEMS TO BE SOLVED BY THE INVENTION

In view of the above-described circumstances, the present invention made it possible to easily produce a high-quality single crystal of a substance that is difficult to produce by an ordinary method using a round rod-shape raw material, and an object of the present invention is to provide a single-crystal production equipment which is capable of producing a large single crystal having a uniform composition in both the vertical and horizontal directions at an optimum dopant concentration.

### TECHNICAL SOLUTION

In order to solve the above-described problems, the present inventor invented a novel single-crystal production equipment.

That is, the present inventor invented a single-crystal production equipment, such as described in claim 1, in which a raw material is supplied in a powder form, instead of being molded into a round rod shape and then supplied as in the basics of conventional methods.

According to such a single-crystal production equipment of the present invention, since the supply of a powder raw material and the crystallization control of a melt are separated and focus can thus be given to stabilizing the crystallization from the melt, the production of a high-quality single crystal or large single crystal that has a complex composition can be carried out extremely easily.

In addition, since the amount of the energy required for melting a raw material is markedly reduced, a major energy saving can be realized as a whole.

In cases where a powder raw material (e.g., silicon powder raw material + dopant doped powder) is drop-supplied onto a melt, if the powder raw material precipitates in the melt and adheres to a seed crystal therebelow, negative crystals and other microcrystals are generated from the adhered powder raw material, and this leads to degradation of the performance of the resulting single crystal as a product.

Generally, comparing a solid of a certain substance and a melt thereof in terms of specific gravity, the solid has a higher specific gravity in many cases. However, as an exception, between ice and water, it is well-known that ice has a lower specific gravity. In the case of semiconductor silicon as well, solid has a lower specific gravity and thus floats on a melt thereof.

In cases where a supplied powder raw material floats on a melt in this manner, since the floating powder raw material can be easily melted by directly irradiating an infrared ray thereto, a floating-zone melting method is extremely convenient for producing a single crystal.

On the other hand, when a powder raw material having a high specific gravity basically sinks and moves downward in a melt, it is difficult to melt the supplied powder raw material. It was discovered that, in such a case, by appropriately selecting the particle size or particle shape of the powder raw material to be supplied, the supplied raw material can sometimes be completely melted by infrared irradiation before sinking in the melt.

Specifically, it was found that a powder raw material in a shape having a low bulk density has a lower apparent density than its melt and thus does not immediately sink and floats on the melt even when it is dropped onto the melt. By melting the powder raw material by infrared irradiation in this period, the supply and melting of the powder raw material and the production of a single crystal through solidification can be continuously carried out without any problem.

In an attempt to drop-supply a powder raw material onto a melt and to melt this powder raw material, the following problems must be addressed.
1) If the supplied powder raw material sinks in the melt and adheres to a solid phase (seed crystal) therebelow, solid powder raw material will adhere to the growth interface. When the solid powder raw material has a sufficiently small size, negative crystals are formed originating from the solid powder raw material. Meanwhile, when the solid powder raw material has a large size, new microcrystals start to grow therefrom, yielding a polycrystal as a whole.
2) The amount of heat required for melting the supplied powder raw material is provided from the surrounding melt; therefore, it is necessary to increase the temperature of the surrounding melt. This inevitably causes elution of a solid phase (seed crystal) underneath the melt, making it difficult to continue the production of a single crystal.

Because of these problems, it has been considered difficult to successfully perform a method of supplying, melting and then solidifying a powder raw material instead of a raw material rod used for the production of a single crystal through melting by local heating and subsequent solidification.

In addition, in a conventional infrared FZ method, since a system where an infrared ray is irradiated from the horizontal direction had been the mainstream, as a matter of practice, a system where a melt formed from a powder raw material molded into a round rod-shape sintered article is retained on a raw material rod arranged thereabove by utilizing the surface tension of the melt has been the method that can most conveniently and stably forming and maintaining such a melt; therefore, the necessity of directly supplying the raw material in a powder form was not noticed in the first place.

The infrared FZ method has been established as a technique where a powder raw material of the subject substance is generally molded and used in a round rod shape and has had many successes being applied for producing single crystals of various substances. However, it has been gradually understood that there are substances for which the production of a high-quality single crystal is totally difficult by the infrared FZ method.

For example, it has been considered that, among high-temperature superconducting substances, a single crystal of La₂CuO₄ can be relatively easily produced by the infrared FZ method; however, the production of a high-quality single crystal of Bi₂Sr₂Ca₂Cu₃O₁₀ is difficult due to the difficulty of forming a stable melt of Bi₂Sr₂Ca₂Cu₃O₁₀.

Meanwhile, an inclined irradiation-type infrared FZ method in which irradiation is made not in the horizontal direction as in a conventional method but from oblique above to a lower part was recently developed, and a large single crystal can now be realistically produced, which was considered impossible by a conventional horizontal irradiation-type infrared FZ method. Consequently, for the system of supplying a raw material as well, it is gradually understood that there are limitations in a system where a powder raw material is molded into a rod shape or a raw material rod is used as in a conventional method.

To produce a single crystal by an infrared FZ method means to produce a single crystal by a melt method where a raw material is melted and solidified. In this case, the production of a large single crystal requires a large raw material rod of an equivalent size or larger. That is, for the production of a single crystal of 300 mm in diameter and 1,000 mm in length, in reality, since the raw material rod is set on an equipment by holding, the held part of the raw material rod cannot be used as a raw material, merely serving as a part for holding.

Accordingly, for the same product of 300 mm in diameter, the raw material rod is required to have a 300 mm in diameter and length of 1,200 mm or greater. Melting of such a large raw material rod requires an extremely large amount of heat. That is, it is sufficient as long as only the lower end of the large raw material rod is melted; however, in order to melt the lower end of the raw material rod, the total amount of the heat therefor is required to include the heat that conducts through and escapes from the raw material rod and the heat that escapes as radiant heat. Therefore, an extremely large infrared generator and a massive power supply equipment for operating the infrared generator are required.

In order to overcome this problem, for example, by using a raw material rod of a half the diameter, the amount of the heat required for melting the raw material rod is largely reduced. However, since the raw material rod of a half the diameter is required to have a length of four times as a whole, either a large equipment must be employed for the use of such an extremely long raw material rod or, for the use of four raw material rods, operations of once discontinuing the growth of a single crystal in the middle of the production and replacing a used raw material rod with new one must be repeated plural times. Furthermore, since the heating cannot be interrupted even in the period when the production operation is discontinued, a greater amount of energy will be consumed overall.

Thus, if only a required amount of the raw material in a powder form could be directly supplied into a transparent quartz tube as well as melted and solidified, the amount of the required heat can be reduced tremendously. This is an elemental technology whose necessity first arose when trying to produce a large single crystal by an inclined irradiation-type infrared FZ method.

Under such circumstances, facing the need to develop a single-crystal production equipment in which a powder raw material is supplied, the present inventor, as an example, first supplied silicon powder raw materials of various sizes into a transparent quartz tube for the production of a silicon single crystal and observed the state thereof.

Using the single-crystal production equipment of the present invention, an upper part of a rod-shape silicon seed crystal having a diameter of 100 mm was melted and a finely-pulverized silicon powder raw material was dropped thereto, after which the behavior and melting characteristics on the surface of the resulting melt were investigated.

It was most concerned that the dropped silicon powder raw material would sink in the melt without being melted, reach a solid phase (seed crystal) therebelow and adhere on the solid phase (seed crystal) and microcrystals would be thereby generated to yield a polycrystal. However, such a result was not obtained, and the dropped powder raw material was melted in a few seconds to several tens of seconds.

It was confirmed that, although the amount of the melt is increased by continuously dropping the powder raw material, a constant melt surface position can be maintained by lowering the silicon seed crystal to compensate the increase, as a result of which a large single crystal can be produced by this novel powder raw material dropping method.

Further, the relationship between the supply of the powder raw material to the entire upper surface of the seed crystal and the distribution of the infrared irradiation dose was investigated.

That is, in cases where a single crystal is actually used as an element to various devices, a single crystal in which a necessary dopant is added in a required amount is needed. For instance, for the use of a silicon single crystal as a solar cell substrate, a phosphorus-doped N-type single crystal or a boron-doped P-type single crystal is required.

In the production of a phosphorus-doped N-type single-crystal substrate, a melt and a single crystal solidified therefrom do not have the same phosphorus concentration, and the concentration of phosphorus in the single crystal will be 0.35, taking the concentration in the melt as 1. This ratio is referred to as "distribution coefficient", and this distribution coefficient indicates a fixed value irrespective of the phosphorus concentration. It is noted here that the single crystal is desired to have a uniform dopant concentration in its entirety.

In a melt method where a powder raw material is melted and then solidified to produce a single crystal, it is necessary to introduce a scheme called "traveling solvent method" for the production of a single crystal having a uniform concentration.

That is, defining the composition of a melt in which a single crystal having a composition Co coexists as C₁, since solidification takes place only from this melt having the composition C₁ including the composition Co, for the production of a uniform single crystal having the composition Co, a certain amount of the melt having the composition C₁ is allowed to coexist and a raw material having the composition Co is drop-supplied into the melt having the composition C₁ in the same amount as the amount of the single crystal having the composition Co that has been generated from the melt.

As a result, the raw material having a uniform composition passes through a solvent phase to yield a single crystal having a uniform composition, so that a single crystal having a uniform composition in its entirety can be produced. In the execution of this scheme, it is obviously most convenient for the production of a uniform-composition product to evenly supply the powder raw material to all parts of the melt formed on the seed crystal and to melt and solidify this powder raw material.

However, when it was actually tried to execute the above-described scheme, occurrence of various inconveniences was confirmed.

That is, during the single crystal production, the melt is held on the upper end surface in the outer part of the seed crystal by the surface tension of the melt itself. Even a slight change in the temperature of this part easily makes the melt drip, which leads to a failure of the single crystal production.

Thus, particularly in the outer part of the seed crystal, it is necessary to avoid a temperature change as much as possible and to thereby stably maintain the melt. Accordingly, the supply of the powder raw material is limited to the vicinity of the center of the seed crystal and the powder raw material is melted there, allowing the resulting melt to naturally flow to the outer part of the seed crystal. This makes the melting and solidification of the powder raw material appear to be proceeding in a stable manner; however, actually, the outer part of the seed crystal receives no fresh supply of the powder raw material and, in terms of the form, a steady state is maintained by the flow of the melt from the vicinity of the center. In terms of the composition, as the solidification proceeds from the vicinity of the center, a remaining melt of the powder raw material melted in the vicinity of the center flows to the outer part.

As described above, the composition of a dopant in the raw powder supplied to the melt and that in the crystal being solidified are not the same, and they are defined by a ratio referred to as "distribution coefficient".

Therefore, between the vicinity of the center and the outer part of the growing single crystal, the dopant concentration tends to increase toward the outer part of the single crystal.

A single crystal is often used after being processed into the form of a wafer. In such a case, with regard to the heterogeneity of the dopant concentration in the wafer, the allowable range is generally approximately 5% or 3% in a stringent case, although it is variable depending on the individual reasons on the device production side.

In order to satisfy this condition, it was investigated how close the supply position of the powder raw material need to be with respect to the outer part of the seed crystal.

As a result, for the production of an N-type silicon single crystal in which phosphorus is doped to silicon, it was confirmed that, by supplying a powder raw material up to a position corresponding to 90% of the diameter of a seed crystal, the powder raw material can be completely melted and the resulting melt can be stably retained, so that the heterogeneity of the dopant concentration in the resulting single crystal can be controlled within 3%.

One of the reasons why melting and solidification of the powder raw material could be achieved under this condition is because irradiation of an infrared ray was carried out using an inclined irradiation-type infrared ray irradiation apparatus, and this made clear that the single-crystal production equipment of the present invention is practical.

Meanwhile, in addition to the above-described production of a large single crystal, for example, in the production of a small single crystal of approximately 5 mm in diameter as well, it was demonstrated that, for a substance for which stable melting of a raw material rod is difficult, a single crystal thereof can be stably produced by directly supplying the powder raw material in a powder form without molding it into a round rod shape.

That is, the powder raw material is melted by irradiating the upper surface of the seed crystal placed therebelow with an infrared ray from obliquely above, and the powder raw material is drop-supplied to the resulting melt in a state of being held on the seed crystal by the surface tension of the melt itself. In this process, the bulk density of the powder raw material is reduced to maintain the state of floating on the melt, and the powder raw material is melted by irradiating thereto an infrared ray.

Since the amount of the melt increases as the melt is generated and the melt would drip if the amount thereof is allowed to keep increasing, the position of the table retaining the seed crystal below was lowered, and the melt in contact with the seed crystal below was allowed to solidify as a single crystal so as to maintain the amount of the melt constant, whereby the supply, melting and solidification of the powder raw material were continuously carried out and a single crystal was produced.

That is, the single-crystal production equipment of the present invention is comprises:
A transparent quartz tube, in which a seed crystal is placed;
a powder raw material supply apparatus, which is arranged above the transparent quartz tube and supplies a powder raw material onto the seed crystal placed in the transparent quartz tube; and
an infrared ray irradiation apparatus, which is arranged outside the transparent quartz tube and applies an infrared ray to the upper surface of the seed crystal placed in the transparent quartz tube as well as the powder raw material supplied into the transparent quartz tube by the powder raw material supply apparatus,
where in the single-crystal production equipment is configured to produce a single crystal by applying the infrared ray from the infrared ray irradiation apparatus into the transparent quartz tube so as to melt an upper surface of the seed crystal and the powder raw material and subsequently solidifying the resulting melt on the seed crystal.

By this configuration, the supplied powder raw material is melted upon receiving the infrared ray and a melt is formed. The amount of the melt formed on the upper surface of the growing single crystal increases as the melting of the powder raw material proceeds and, in the outer part of the single crystal (seed crystal) therebelow, the melt gradually expands toward the outer side.

As this condition progresses, the amount of the melt increases excessively and the melt will eventually drips down; therefore, prior to this point, the table on which the single crystal below is placed is lowered, the solidification is allowed to proceed and the lowering speed of the table is adjusted such that the amount of the material being solidified and the amount of the material being supplied are the same, whereby a stable condition can be maintained. In addition, a single crystal having the same optimum dopant concentration as the supplied powder raw material having a prescribed dopant concentration can be grown, so that a single crystal that is uniform in its entirety at the optimum dopant concentration can be produced.

The single-crystal production equipment of the present invention is characterized in that an auxiliary heating apparatus, which heats an outer part of the seed crystal, is arranged.

With an auxiliary heating apparatus being arranged outside the transparent quartz tube in this manner, the dose of the infrared ray to be irradiated can be reduced and the controllability can be improved by heating the outer part of the seed crystal in advance and then melting the powder raw material by irradiating thereto an infrared ray using the infrared ray irradiation apparatus.

Therefore, the powder raw material can be melted efficiently. The auxiliary heating apparatus may be configured to heat the powder raw material by irradiating thereto an infrared ray from outside the transparent quartz tube, or may be configured as a cylindrical resistance heating-type electric furnace that is arranged inside the transparent quartz tube and around the single crystal being produced and performs the heating to a prescribed temperature.

The single-crystal production equipment of the present invention is also characterized in that the powder raw material supply apparatus comprises:
a hopper which stores the powder raw material;
a supply adjustment unit which supplies a prescribed amount of the powder raw material stored in the hopper to a prescribed position in the transparent quartz tube; and
a supply pipe which is arranged on a lower end of the supply adjustment unit and through which the powder raw material is supplied into the quartz crucible.

By this configuration, the powder raw material can be surely supplied into the transparent quartz tube.

Further, the single-crystal production equipment of the present invention is characterized in that the supply adjustment unit comprises a supply rate adjustment apparatus which adjusts a rate at which the powder raw material is supplied into the transparent quartz tube.

With the supply adjustment unit being configured in this manner, for example, by increasing the supply rate in the vicinity of the center of upper surface of the cylindrical seed crystal while decreasing the supply rate toward the outer part of the seed crystal, the amount of the powder raw material to be supplied can be reduced in the vicinity of the center of upper surface of the seed crystal and increased toward the outer part, as a result of which the powder raw material can be uniformly supplied on the seed crystal.

Still further, the single-crystal production equipment of the present invention is characterized in that the supply adjustment unit comprises a supply position adjustment apparatus which adjusts a position at which the powder raw material is supplied in the transparent quartz tube.

As long as the supply position can be adjusted in this manner, the powder raw material can be uniformly supplied on the seed crystal.

Yet still further, the single-crystal production equipment of the present invention is characterized in that the hopper is configured such that a powder raw material container, which stores the powder raw material, is detachably attached thereto.

When the powder raw material container can be attached or detached as desired in this manner, the powder raw material can be freshly supplied even in the midst of operating the single-crystal production equipment to produce a single crystal, and this enables to continuously supply a required amount of the powder raw material into the transparent quartz tube at all times without having to hold an extremely large powder raw material container, so that an increase in the size of the equipment can be avoided.

Yet still further, the single-crystal production equipment of the present invention is characterized in that the supply pipe is made of quartz.

With the supply pipe being made of quartz in this manner, there are advantages that the quartz pipe does not get heated since it does not absorb the infrared ray and that, since the quartz pipe has a smooth surface, the amount of the supplied powder raw material retained thereon through adhesion is reduced.

Yet still further, the single-crystal production equipment of the present invention is characterized in that the hopper comprises:
a hopper for crystal base material powder, which stores a crystal base material powder; and
a hopper for dopant doped powder, which stores a dopant doped powder.

By storing the crystal base material powder and the dopant doped powder in separate hoppers in this manner, a desired composition ratio can be easily attained in the supply adjustment unit.

For example, when growing a phosphorus-doped N-type silicon single crystal, the powder raw material to be supplied first is adjusted to have a phosphorus concentration that is three times higher than that of an optimum-concentration composition, and this powder raw material is supplied in the same amount as that of a melt phase formed in a steady state. Then, the powder raw material having the optimum-concentration composition is supplied in an amount controlled to be the same as that of the material being solidified, whereby the resulting single crystal is allowed to have a composition that roughly conforms to the optimum-concentration composition from the beginning, so that the good-quality product yield as a whole can be improved.

Yet still further, the single-crystal production equipment of the present invention is characterized in that the hopper is a hopper for mixed powder, which stores a mixed powder obtained by mixing a crystal base material powder and a dopant doped powder.

In this manner, by mixing in advance the crystal base material powder and the dopant doped powder and storing them in the form of a mixed powder, the size of the equipment can be reduced as compared to a case where different hoppers are separately arranged, and a certain composition ratio can be surely maintained.

In this case, however, the dopant concentration of a melt phase initially formed on the seed crystal is required to be higher than that of the powder raw material at a ratio defined by distribution coefficient. Therefore, a solid in an amount corresponding to the required amount of a solvent phase is separately prepared at a high concentration and placed on the seed crystal in advance, and this solid is melted first to form a solvent phase and the powder raw material starts to be supplied thereafter, whereby a single crystal having a uniform composition in its entirety can be produced.

Yet still further, the single-crystal production equipment of the present invention is characterized in that the hopper comprises:
a hopper for crystal base material powder, which stores a crystal base material powder; and
a hopper for mixed powder, which stores a mixed powder obtained by mixing a crystal base material powder and a dopant doped powder.

By preparing and storing a crystal base material powder and a mixed powder separately in this manner, a single crystal having a uniform composition in both the vertical and horizontal directions at an optimum dopant concentration can be produced.

Yet still further, the single-crystal production equipment of the present invention is characterized in that the crystal base material powder is a silicon powder.

When the crystal base material powder is a silicon powder in this manner, for example, a silicon single crystal used in a semiconductor-related product can be produced.

Yet still further, the single-crystal production equipment of the present invention is characterized in that the powder raw material supply apparatus is configured to supply the powder raw material to within 90% of a diameter of the seed crystal.

By supplying the powder raw material to within 90% of the diameter of the seed crystal in this manner, the powder raw material can be safely melted and the resulting melt can be stably maintained, so that a single crystal having a uniform composition in both the vertical and horizontal directions at an optimum dopant concentration can be produced.

Yet still further, the single-crystal production equipment of the present invention is characterized in that the infrared ray irradiation apparatus is configured to apply said infrared ray to within 90% of a diameter of the seed crystal.

By heating the part within 90% of the diameter of the seed crystal in this manner, the powder raw material can be safely melted and the resulting melt can be stably maintained, so that a single crystal having a uniform composition in both the vertical and horizontal directions at an optimum dopant concentration can be produced.

Yet still further, the single-crystal production equipment of the present invention is characterized in that the infrared ray irradiation apparatus comprises:
an elliptical reflector whose inner surface is used as a reflection surface; and
an infrared lamp which is arranged at a first focus position on a bottom side of the elliptical reflector.

By using such an infrared ray irradiation apparatus, an infrared ray can be efficiently irradiated to the powder raw material.

Yet still further, the single-crystal production equipment of the present invention is characterized in that the infrared lamp is a halogen lamp or a xenon lamp.

Since a halogen lamp or a xenon lamp can be obtained inexpensively, the production cost of the single-crystal production equipment can be reduced.

Yet still further, the single-crystal production equipment of the present invention is characterized in that the infrared ray irradiation apparatus is a semiconductor laser module which applies a laser beam of the infrared ray.

By using a semiconductor laser module in this manner, the size of the infrared ray irradiation apparatus can be reduced, which contributes to downsizing of the single-crystal production equipment.

Yet still further, the single-crystal production equipment of the present invention is characterized in that a plurality of the infrared ray irradiation apparatus is arranged.

By arranging a plurality of infrared ray irradiation apparatuses in this manner, the powder raw material can be more stably and surely melted as compared to a case where only one infrared ray irradiation apparatus is arranged. In addition, with the infrared ray irradiation apparatus being arranged in plural number in this manner, the melting surface of the quartz crucible can be heated uniformly.

By uniformly heating the melting surface, a single crystal having a uniform composition in both the vertical and horizontal directions can be produced.

Yet still further, the single-crystal production equipment of the present invention is characterized in that a table on which the seed crystal is placed is arranged in a lower part of the transparent quartz tube.

With the seed crystal being placed on the table in this manner, by moving the table as appropriate in accordance with the growth state of the single crystal, a single crystal having a uniform composition in both the vertical and horizontal directions can be produced.

Yet still further, the single-crystal production equipment of the present invention is characterized in that the table comprises a rotary drive apparatus.

With the table being configured to be rotatable in this manner, an infrared ray can be uniformly irradiated from the infrared ray irradiation apparatus, so that the powder raw material can be heated evenly. As a result, a single crystal having a uniform composition in both the vertical and horizontal directions can be produced.

Yet still further, the single-crystal production equipment of the present invention is characterized in that the table comprises an elevator apparatus which moves in the vertical direction at a prescribed speed.

With the table being movable in the vertical direction in this manner, the amount of the supplied powder raw material and that of the growing single crystal can be controlled to be the same, which is convenient.

Yet still further, the single-crystal production equipment of the present invention is characterized by comprising an atmosphere control apparatus which vacuum-evacuates the atmosphere in the transparent quartz tube and/or replaces the atmosphere with an inert gas.

By vacuum-evacuating the atmosphere in the transparent quartz tube and/or replacing the atmosphere with an inert gas in this manner, even when an oxidizable material is used, oxidation thereof through reaction with the air is inhibited, so that a high-purity and high-quality single crystal containing no impurity can be produced.

### ADVANTAGEOUS EFFECTS OF THE INVENTION

According to the single-crystal production equipment of the present invention, since a powder raw material (crystal base material powder (e.g., silicon powder) + dopant doped powder) is continuously supplied in the same amount as that of the material being crystallized in accordance with the growth of a single crystal, it is not necessary to restrict the diameter, length and the like of a raw material rod as in conventional equipment, and a single crystal having any diameter and any length can be produced.

In addition, as compared to conventional single-crystal production equipments using a raw material rod, the amount of the energy required for the production of a single crystal can be largely reduced, and the production cost can thus be reduced.

Moreover, a large single crystal having a uniform composition in both the vertical and horizontal directions can be produced at a low cost.

### BRIEF DESCRIPTION OF THE DRAWINGS

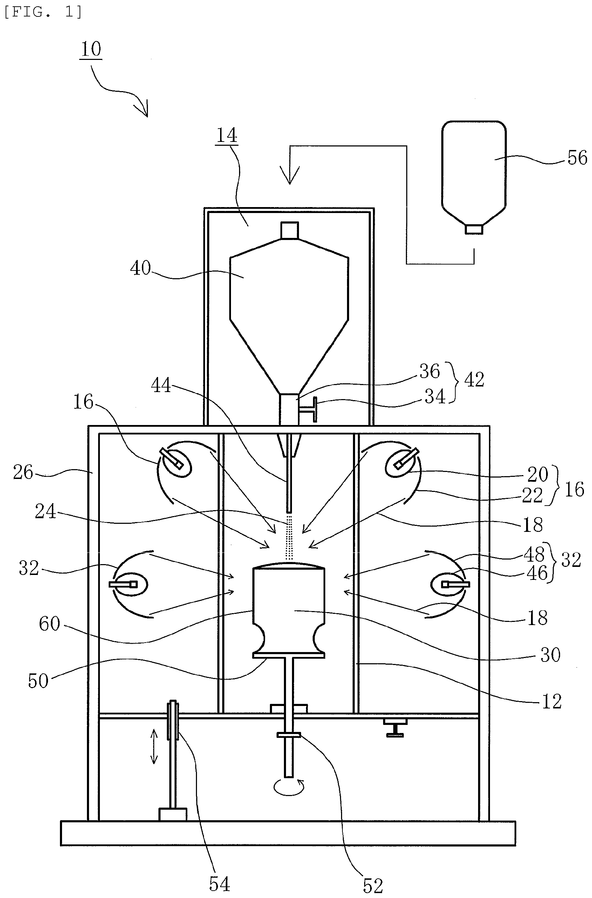

[FIG. 1] FIG. 1 is a schematic view showing a single-crystal production equipment according to one embodiment of the present invention.

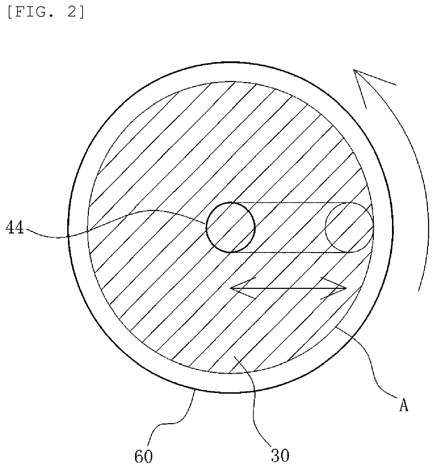

[FIG. 2] FIG. 2 is a drawing of the single-crystal production equipment shown in FIG. 1 as viewed from the above and is used for explaining the supply range of a powder raw material.

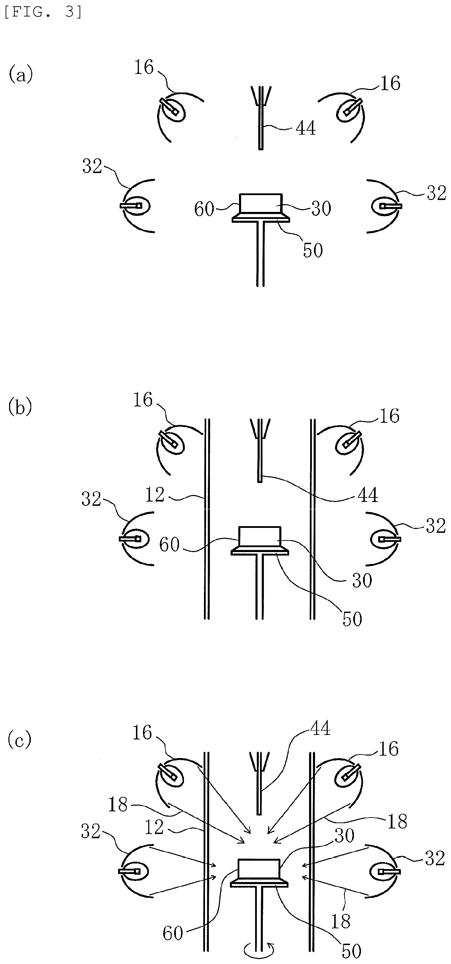

[FIG. 3] FIG. 3 is a process diagram showing the production steps of a single crystal using the single-crystal production equipment of the present invention, wherein FIG. 3(a) depicts a state where a seed crystal is placed on a table, FIG. 3(b) depicts a state where a transparent quartz tube is arranged around the seed crystal, and FIG. 3 (c) depicts a state of infrared irradiation carried out by infrared heating apparatuses and auxiliary heating apparatuses.

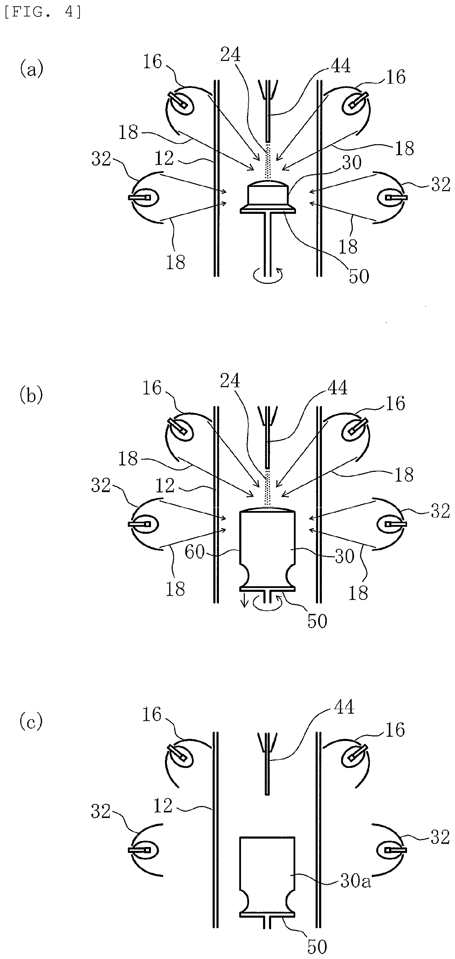

[FIG. 4] FIG. 4 is a process diagram showing the production steps of a single crystal using the single-crystal production equipment of the present invention, wherein FIG. 4(a) depicts a state where a powder raw material is supplied onto the seed crystal, FIG. 4(b) depicts a state of growing a single crystal while lowering the table using an elevator apparatus, and FIG. 4(c) depicts a state where the production of the single crystal has been completed with termination of the infrared irradiation by the infrared heating apparatuses and auxiliary heating apparatuses.

### MODE FOR CARRYING OUT THE INVENTION

Embodiments of the present invention will now be described in more detail based on the drawings.

The single-crystal production equipment of the present invention is used for highly efficiently producing a large single crystal of, for example, 200 to 300 mm or larger in diameter, while avoiding contamination by impurities and homogenizing its composition to be optimum at a high purity.

The term "seed crystal" used herein refers to an initial form of a crystal in the production of a large single crystal using a single-crystal production equipment. A crystal which is grown from the seed crystal and maintains the same orientation in its entirety is referred to as "single crystal".

### <Single-Crystal Production Equipment 10>

As shown in FIG. 1, a single-crystal production equipment 10 of the present Example comprises: a transparent quartz tube 12, in which a seed crystal 30 is placed; a powder raw material supply apparatus 14, which is arranged above the transparent quartz tube 12 and supplies a powder raw material 24, which is composed of a silicon powder and a dopant doped powder, onto the seed crystal 30 placed in the transparent quartz tube 12; and an infrared ray irradiation apparatus 16, which is arranged outside the transparent quartz tube 12 and irradiates an infrared ray 18 to the powder raw material 24, which is supplied into the transparent quartz tube 12 by the powder raw material supply apparatus 14, from obliquely above in the downward direction.

In addition, in the single-crystal production equipment 10 of the present invention, an auxiliary heating apparatus 32, which heats the outer part of the seed crystal 30, is arranged outside the transparent quartz tube 12.

The auxiliary heating apparatus 32 is used for heating an outer part 60 of the seed crystal 30 in advance and, when the powder raw material 24 is melted by irradiating thereto the infrared ray 18 from the infrared ray irradiation apparatus 16 in a state where the outer part 60 of the seed crystal 30 has been heated in this manner, the irradiation dose of the infrared ray 18 can be reduced and the controllability can be improved.

As the infrared ray irradiation apparatus 16 used for irradiating the infrared ray 18 to the powder raw material 24 and the auxiliary heating apparatus 32 used for heating the outer part 60 of the seed crystal 30, for example, those which are configured such that the infrared ray 18 emitted from an infrared lamp 20 or 46 is reflected by the inner surface of an elliptical reflector 22 or 48 can be used.

As the infrared lamps 20 and 46, for example, a halogen lamp or a xenon lamp can be used. Since a halogen lamp or a xenon lamp can be obtained inexpensively, the production cost of the single-crystal production equipment 10 can be reduced. The number of the infrared ray irradiation apparatuses 16 and that of the auxiliary heating apparatuses 32 are not restricted to one, and a plurality of these apparatuses may be arranged. In cases where a plurality of these apparatuses are arranged, it is preferred to circumferentially arrange them at regular intervals around the seed crystal 30 since this enables to achieve uniform heating.

Alternatively to the case where the infrared ray irradiation apparatus 16 and the auxiliary heating apparatus 32 are constituted by the infrared lamps 20 and 46 and the elliptical reflectors 22 and 48, respectively, these apparatuses may be semiconductor laser modules (not shown). By using semiconductor laser modules (not shown), the infrared ray irradiation apparatus 16 and the auxiliary heating apparatus 32 can be reduced in size, which contributes to downsizing of the single-crystal production equipment 10.

In the single-crystal production equipment 10 of the present invention, the transparent quartz tube 12 is arranged in a closed chamber 26, and the infrared ray irradiation apparatus 16 and the auxiliary heating apparatus 32 are arranged externally to the transparent quartz tube 12 in the closed chamber 26. It is noted here, however, that the arrangement of the auxiliary heating apparatus 32 is not restricted thereto, and the auxiliary heating apparatus 32 may be a cylindrical resistance heating-type electric furnace (not shown) arranged externally to the seed crystal 30 but inside the transparent quartz tube 12.

Further, the transparent quartz tube 12 is configured such that it can be vacuum-evacuated by an atmosphere control apparatus (not shown) and retain an inert gas atmosphere such as argon gas inside. By vacuum-evacuating the atmosphere in the transparent quartz tube 12 and replacing the atmosphere with an inert gas atmosphere, even when an oxidizable material is used, oxidation thereof through reaction with the air can be inhibited.

Meanwhile, the seed crystal 30 is placed on a table 50 arranged in a lower part of the transparent quartz tube 12, and this table 50 is configured to be rotated by a rotary drive apparatus 52. By rotating the table 50 in this manner, the infrared ray 18 can be uniformly irradiated to the powder raw material 24 from the infrared ray irradiation apparatus 16, so that the powder raw material 24 can be evenly heated.

Further, the table 50 is also configured to be movable in the vertical direction as desired using an elevator apparatus 54 and, as described below, by lowering the table 50 as the growth of a single crystal proceeds, the size of the single crystal can be increased.

Meanwhile, above the transparent quartz tube 12, the powder raw material supply apparatus 14 is arranged, and this powder raw material supply apparatus 14 comprises: a hopper 40, which stores a powder raw material 24; a supply adjustment unit 42, which supplies a prescribed amount of the powder raw material 24 stored in the hopper 40 to a prescribed position of the transparent quartz tube 12; and a supply pipe 44, which is arranged on the lower end of the supply adjustment unit 42 and through which the powder raw material 24 is supplied into the transparent quartz tube 12.

The supply adjustment unit 42 comprises: a supply rate adjustment apparatus 34 which adjusts the rate at which the powder raw material 24 is supplied into the transparent quartz tube 12; and a supply position adjustment apparatus 36 which adjusts the supply position, and this configuration enables to adjust the supply of the powder raw material 24 in accordance with the growth state of a single crystal.

The hopper 40 in this embodiment is a hopper for mixed powder, which stores a mixed powder obtained by mixing a silicon powder and a dopant doped powder, and this enables to surely maintain the composition ratio of the powder raw material 24 constant.

In this case, however, the dopant concentration of a melt phase initially formed on the seed crystal 30 is required to be higher than that of the powder raw material 24 at a ratio defined by distribution coefficient. Therefore, a solid in an amount corresponding to the required amount of a solvent phase is separately prepared at a high concentration and placed on the seed crystal 30 in advance, and this solid is melted first to form a solvent phase and the powder raw material 24 starts to be supplied thereafter, whereby a single crystal 30a having a uniform composition in its entirety can be produced.

In this embodiment, a hopper for mixed powder is used as the hopper 40; however, the hopper 40 is not restricted thereto and, for example, the hopper 40 may be constituted by both a hopper for silicon powder which stores a silicon powder and a hopper for dopant doped powder which stores a dopant doped powder.

By using both a hopper for silicon powder and a hopper for dopant doped powder in this manner, a desired composition ratio can be easily achieved in the supply adjustment unit 42.

For example, when growing a phosphorus-doped N-type silicon single crystal, the powder raw material 24 to be supplied first is adjusted to have a phosphorus concentration that is three times higher than that of an optimum-concentration composition, and this powder raw material 24 is supplied in the same amount as that of a melt phase formed in a steady state, after which the powder raw material 24 having the optimum-concentration composition is supplied in an amount controlled to be the same as that of the material being solidified, whereby the resulting single crystal 30a is allowed to have a composition that roughly conforms to the optimum-concentration composition from the beginning, so that the good-quality product yield as a whole can be improved.

As an alternative to the above-described combination of a hopper for silicon powder and a hopper for dopant doped powder, a combination of a hopper for silicon powder and a hopper for mixed powder, which stores a mixed powder obtained by mixing a silicon powder and a dopant doped powder, may be used as well.

The upper end of such a hopper 40 is configured such that a powder raw material container 56, which stores the powder raw material 24, can be attached to and detached from as desired (FIG. 1 shows a state where the powder raw material container 56 is detached).

By using such a powder raw material container 56, the powder raw material 24 can be freshly supplied even in the midst of operating the single-crystal production equipment 10 to produce a single crystal, and this enables to continuously supply a required amount of the powder raw material 24 into the transparent quartz tube 12 at all times without having to hold an extremely large powder raw material container 56 over the hopper 40, so that an increase in the size of the single crystal production equipment 10 can be avoided.

The powder raw material container 56 is preferably configured in conformity with the specifications of the hopper 40. For example, as in this embodiment, when the hopper 40 is a hopper for mixed powder which stores a mixed powder obtained by mixing a silicon powder and a dopant doped powder, it is preferred that the powder raw material container 56 be configured to store the mixed powder.

Meanwhile, when the hopper 40 is constituted by a combination of a hopper for silicon powder and a hopper for dopant doped powder, the powder raw material container 56 may be a combination of a container for silicon powder and a container for dopant doped powder.

Further, the supply pipe 44 of the powder raw material 24 is configured such that, by the supply adjustment unit 42 arranged above the supply pipe 44, a prescribed amount of the powder raw material 24 is supplied therethrough to a prescribed position on the seed crystal 30 placed in the transparent quartz tube 12.

As shown in FIG. 2, the supply pipe 44 is arranged above the seed crystal 30 placed in the transparent quartz tube 12 and configured such that it can be moved between a central position above the seed crystal 30 and a position of the outer part 60.

It is preferred that the powder raw material 24 be supplied from the supply pipe 44 to an area A which corresponds to 90% or less of the diameter of the seed crystal 30. In this manner, by supplying the powder raw material 24 such that the supply stops before reaching the outer part 60 of the seed crystal 30, the powder raw material 24 can be safely melted and the resulting melt can be stably maintained, so that the single crystal 30a that has a uniform composition in both the vertical and horizontal directions at an optimum dopant concentration can be produced.

As for the position and amount at which the powder raw material 24 is supplied from the supply pipe 44, they are desirably determined using the supply position adjustment apparatus 36 and the supply rate adjustment apparatus 34 of the supply adjustment unit 42, respectively.

For example, by reducing the supply amount of the powder raw material 24 in the vicinity of the center of the seed crystal 30 and increasing the supply amount toward the outer part 60 of the seed crystal 30, the powder raw material 24 is evenly supplied anywhere on the seed crystal 30 and can thus be surely melted, and the single crystal 30a that has a uniform composition in both the vertical and horizontal directions at an optimum dopant concentration can be produced.

The material of such a supply pipe 44 is preferably quartz. Since quartz does not absorb the infrared ray 18, it does not cause a temperature increase by absorbing stray light from the infrared source and, since quartz has a smooth surface, the amount of the powder raw material 24 retained thereon can be reduced, which are preferred.

Moreover, in the single-crystal production equipment 10 of the present invention, when heating the powder raw material 24 using the infrared ray irradiation apparatus 16, it is preferred to irradiate the infrared ray 18 to within 90% of the diameter of the seed crystal 30.

In this process as well, in the same manner as for the position at which the powder raw material 24 is supplied from the supply pipe 44, by heating the powder raw material 24 such that the heating stops before reaching the outer part 60 of the seed crystal 30, not only the surface of the growing single crystal can be maintained flat but also the powder raw material 24 can be safely melted and the resulting melt can be stably maintained, so that the single crystal 30a that has a uniform composition in both the vertical and horizontal directions at an optimum dopant concentration can be produced.

The single-crystal production equipment 10 according to one Example of the present invention is configured in the above-described manner, and a single-crystal production method using the single-crystal production equipment 10 will now be described.

### <Single-Crystal Production Method>

First, as shown in FIG. 3(a), the seed crystal 30 is placed on the table 50 in the closed chamber 26.

Next, as shown in FIG. 3(b), the transparent quartz tube 12 is arranged externally to the seed crystal 30 in such a manner to surround the seed crystal 30 and, using an atmosphere control apparatus (not shown), the atmosphere inside the transparent quartz tube 12 is vacuum-evacuated, and an inert gas (e.g., argon gas) or an atmosphere gas (e.g., oxygen) is introduced to the transparent quartz tube 12 in accordance with the type of the single crystal to be grown.

In this state, as shown in FIG. 3(c), the seed crystal 30 is subsequently heated by irradiating its upper part and side surface simultaneously with the infrared ray 18 emitted from the infrared ray irradiation apparatus 16 arranged obliquely above the seed crystal 30 and the infrared ray 18 emitted from the auxiliary heating apparatus 32 arranged laterally to the seed crystal 30, respectively. In this process, the table 50 on which the seed crystal 30 is rotated in the circumferential direction.

Then, as shown in FIG. 4(a), once the upper part of the seed crystal 30 is melted, a small amount of the powder raw material 24 is supplied thereto from the supply pipe 44. In this state, the supply and melting of the powder raw material 24 as well as solidification on the seed crystal 30 in the lower part are continuously carried out to allow a single crystal to grow continuously. Thereafter, as shown in FIG. 4(b), the single crystal is allowed to increase its size by lowering the table 50 in accordance with the growth rate of the single crystal.

Once the single crystal has grown to a prescribed size, as shown in FIG. 4(c), the irradiation of the infrared ray 18 from the infrared ray irradiation apparatus 16 and the auxiliary heating apparatus 32 is gradually reduced and eventually terminated completely.

After solidification of the entire material is finished and the temperature is decreased to room temperature, the closed chamber 26 is opened and the single crystal (solidified product) 30a is taken out of the transparent quartz tube 12, whereby the production of the single crystal 30a is completed.

As described above, in the single-crystal production equipment 10 of the present invention, since the process of supplying the powder raw material 24 into the transparent quartz tube 12 as well as the melting and subsequent solidification processes are continuously carried out and a single crystal is produced while continuously supplying the powder raw material 24 into the transparent quartz tube 12 in the same amount as that of the material being solidified, the composition of the resulting crystal can be made uniform.

The single-crystal production equipment 10 of the present invention and a single-crystal production method using the single-crystal production equipment 10 have been described thus far; however, the present invention is not restricted to the above-described embodiments.

For instance, in the above-described embodiment, a case where a silicon powder is used as the crystal base material powder was described as an example; however, the crystal base material powder is not restricted thereto, and any powder prepared in accordance with the substance desired to be produced can be used.

Further, no particular mention is made above with regard to the particle size of the powder raw material (silicon powder + dopant doped powder) 24; however, when the particle size is excessively large, it takes time to melt the particles, and the particles, upon falling into the transparent quartz tube 12, may sink through the melt phase and reach the surface of the solidified product below.

If the powder raw material 24 reaches the surface of the solidified product, the powder raw material 24 is incorporated into the solidified product, and the growth of other crystals tends to start therefrom.

Meanwhile, if the powder raw material 24 has an excessively small particle size, since the particles thereof are scattered in the surrounding when they are allowed to fall toward the transparent quartz tube 12, the controllability is impaired. Accordingly, the particles of the powder raw material 24 preferably have a size of about 0.5 mm in diameter.

In the above-described manner, a variety of modifications can be made in the single-crystal production equipment 10 of the present invention within the scope of the objects of the present invention, as defined in the appended claims.

### DESCRIPTION OF SYMBOLS

- 10:: single-crystal production equipment
- 12:: transparent quartz tube
- 14:: powder raw material supply apparatus
- 16:: infrared ray irradiation apparatus
- 18:: infrared ray
- 20:: infrared lamp
- 22:: elliptical reflector
- 24:: powder raw material
- 26:: closed chamber
- 30:: seed crystal
- 30a:: single crystal
- 32:: auxiliary heating apparatus
- 34:: supply rate adjustment apparatus
- 36:: supply position adjustment apparatus
- 40:: hopper
- 42:: supply adjustment unit
- 44:: supply pipe
- 46:: infrared lamp
- 48:: elliptical reflector
- 50:: table
- 52:: rotary drive apparatus
- 54:: elevator apparatus
- 56:: powder raw material container
- 60:: outer part
- A:: area

## Claims

1. A single-crystal production equipment (10) comprising, at least:
a transparent quartz tube (12), in which a seed crystal (30) is placed;
a powder raw material supply apparatus (14), which is arranged above said transparent quartz tube (12) and supplies a powder raw material (24) onto said seed crystal (30) placed in said transparent quartz tube (12); and
an infrared ray irradiation apparatus (16), which is arranged outside said transparent quartz tube (12) and applies an infrared ray (18) to the upper surface of said seed crystal (30) placed in said transparent quartz tube (12) as well as said powder raw material supplied into said transparent quartz tube (12) by said powder raw material supply apparatus (14),
wherein said single-crystal production equipment (10) is configured to produce a single crystal (30a) by applying said infrared ray (18) from said infrared ray irradiation apparatus (16) into said transparent quartz tube (12) so as to melt an upper surface of said seed crystal (30) and said powder raw material (24) and subsequently solidifying the resulting melt on said seed crystal (30) and
wherein said infrared ray irradiation apparatus (16) is configured to apply said infrared ray (18) to within 90% of a diameter of said seed crystal (30),
wherein said infrared ray irradiation apparatus (16) comprises:
an elliptical reflector (22) whose inner surface is used as a reflection surface; and
an infrared lamp (20) which is arranged at a first focus position on a bottom side of said elliptical reflector (22),
or wherein said infrared ray irradiation apparatus (16) is a semiconductor laser module which applies a laser beam of said infrared ray (18).

2. The single-crystal production equipment (10) according to claim 1, wherein an auxiliary heating apparatus (32), which heats an outer part (60) of said seed crystal (30), is arranged.

3. The single-crystal production equipment (10) according to claim 1 or 2, wherein said powder raw material supply apparatus (14) comprises:
a hopper (40) which stores said powder raw material (24);
a supply adjustment unit (42) which supplies a prescribed amount of said powder raw material (24) stored in said hopper to a prescribed position in said transparent quartz tube (12); and
a supply pipe (44) which is arranged on a lower end of said supply adjustment unit (42) and through which said powder raw material (24) is supplied into said transparent quartz tube (12).

4. The single-crystal production equipment (10) according to claim 3, wherein said supply adjustment unit (42) comprises a supply rate adjustment apparatus (34) which adjusts a rate at which said powder raw material (24) is supplied into said transparent quartz tube (12).

5. The single-crystal production equipment (10) according to claim 3 or 4, wherein said supply adjustment unit (42) comprises a supply position adjustment apparatus (36) which adjusts a position at which said powder raw material (24) is supplied in said transparent quartz tube (12).

6. The single-crystal production equipment (10) according to any one of claims 3 to 5, wherein said hopper (40) is configured such that a powder raw material container (56), which stores said powder raw material (24), is detachably attached thereto.

7. The single-crystal production equipment (10) according to any one of claims 3 to 6, wherein said supply pipe (44) is made of quartz.

8. The single-crystal production equipment (10) according to any one of claims 3 to 7, wherein said hopper (40) comprises:
a hopper for crystal base material powder, which stores a crystal base material powder; and
a hopper for dopant doped powder, which stores a dopant doped powder.

9. The single-crystal production equipment (10) according to any one of claims 3 to 7, wherein said hopper (40) is a hopper for mixed powder, which stores a mixed powder obtained by mixing a crystal base material powder and a dopant doped powder.

10. The single-crystal production equipment (10) according to any one of claims 3 to 7, wherein said hopper (40) comprises:
a hopper for crystal base material powder, which stores a crystal base material powder; and
a hopper for mixed powder, which stores a mixed powder obtained by mixing said crystal base material powder and a dopant doped powder.

11. The single-crystal production equipment (10) according to any one of claims 1 to 10, wherein said powder raw material supply apparatus (14) is configured to supply said powder raw material (24) to within 90% of a diameter of said seed crystal (30) .

12. The single-crystal production equipment (10) according to any one of claims 1 to 11, wherein said infrared lamp (20) is a halogen lamp or a xenon lamp.

13. The single-crystal production equipment (10) according to any one of claims 1 to 12, wherein a plurality of said infrared ray irradiation apparatus (16) is arranged.

14. The single-crystal production equipment (10) according to any one of claims 1 to 13, wherein a table (50) on which said seed crystal (30) is placed is arranged in a lower part of said transparent quartz tube (12).

15. The single-crystal production equipment (10) according to claim 14, wherein said table comprises a rotary drive apparatus (52).

16. The single-crystal production equipment (10) according to claim 14 or 15, wherein said table comprises an elevator apparatus (54) which moves in the vertical direction at a prescribed speed.

17. The single-crystal production equipment (10) according to any one of claims 1 to 16, comprising an atmosphere control apparatus which vacuum-evacuates the atmosphere in said transparent quartz tube (12) and/or replaces said atmosphere with an inert gas.

## Patentansprüche

1. Einkristallzüchtungsvorrichtung (10), die mindestens aufweist:
ein transparentes Quarzrohr (12), in dem ein Impfkristall (30) angeordnet ist;
eine Pulverrohmaterialzufuhreinrichtung (14), die über dem transparenten Quarzrohr (12) angeordnet ist und ein Pulverrohmaterial (24) auf den im transparenten Quarzrohr (12) angeordneten Impfkristall (30) zuführt; und
eine Infrarotbestrahlungseinrichtung (16), die außerhalb des transparenten Quarzrohrs (12) angeordnet ist und der Oberseite des im transparenten Quarzrohr (12) angeordneten Impfkristall (30) sowie dem Pulverrohmaterial, das durch die Pulverrohmaterialzufuhreinrichtung (14) in das transparente Quarzrohr (12) zugeführt wird, einen Infrarotstrahl (18) zuführt,
wobei die Einkristallzüchtungsvorrichtung (10) dafür konfiguriert ist, einen Einkristall (30a) zu erzeugen durch Zuführen des Infrarotstrahls (18) von der Infrarotstrahlbestrahlungseinrichtung (16) in das transparente Quarzrohr (12), um eine obere Fläche des Impfkristalls (30) und das Pulverrohmaterial (24) zu schmelzen und anschließend die erhaltene Schmelze auf dem Impfkristall (30) zu verfestigen, und
wobei die Infrarotstrahlbestrahlungseinrichtung (16) dafür konfiguriert ist, den Infrarotstrahl (18) innerhalb von 90% eines Durchmessers des Impfkristalls (30) zuzuführen,
wobei die Infrarotstrahlbestrahlungseinrichtung (16) aufweist:
einen elliptischen Reflektor (22), dessen Innenfläche als Reflexionsfläche verwendet wird; und
eine Infrarotlampe (20), die an einer ersten Fokusposition an einer Unterseite des elliptischen Reflektors (22) angeordnet ist,
oder wobei die Infrarotstrahlbestrahlungseinrichtung (16) ein Halbleiterlasermodul ist, das einen Laserstrahl des Infrarotstrahls (18) zuführt.

2. Einkristallzüchtungsvorrichtung (10) nach Anspruch 1, wobei eine Zusatzheizeinrichtung (32) vorgesehen ist, die einen äußeren Teil (60) des Impfkristalls (30) erwärmt.

3. Einkristallzüchtungsvorrichtung (10) nach Anspruch 1 oder 2, wobei die Pulverrohmaterialzufuhreinrichtung (14) aufweist:
einen Trichter (40), der das Pulverrohmaterial (24) speichert;
eine Zufuhreinstelleinheit (42), die eine vorgegebene Menge des in dem Trichter gespeicherten Pulverrohmaterials (24) zu einer vorgegebenen Position in dem transparenten Quarzrohr (12) zuführt; und
ein Zufuhrrohr (44), das an einem unteren Ende der Zufuhreinstelleinheit (42) angeordnet ist und durch das das Pulverrohmaterial (24) in das transparente Quarzrohr (12) zugeführt wird.

4. Einkristallzüchtungsvorrichtung (10) nach Anspruch 3, wobei die Zufuhreinstelleinheit (42) eine Zufuhrrateneinstelleinrichtung (34) aufweist, die eine Rate einstellt, mit der das Pulverrohmaterial (24) in das transparente Quarzrohr (12) zugeführt wird.

5. Einkristallzüchtungsvorrichtung (10) nach Anspruch 3 oder 4, wobei die Zufuhreinstelleinheit (42) eine Zufuhrpositionseinstelleinrichtung (36) aufweist, die eine Position einstellt, an der das Pulverrohmaterial (24) in das transparente Quarzrohr (12) zugeführt wird.

6. Einkristallzüchtungsvorrichtung (10) nach einem der Ansprüche 3 bis 5, wobei der Trichter (40) derart konfiguriert ist, dass ein Pulverrohmaterialbehälter (56), der das Pulverrohmaterial (24) speichert, abnehmbar daran befestigt ist.

7. Einkristallzüchtungsvorrichtung (10) nach einem der Ansprüche 3 bis 6, wobei das Zufuhrrohr (44) aus Quarz hergestellt ist.

8. Einkristallzüchtungsvorrichtung (10) nach einem der Ansprüche 3 bis 7, wobei der Trichter (40) aufweist:
einen Trichter für Kristallbasismaterialpulver, der ein Kristallbasismaterialpulver speichert; und
einen Trichter für mit einem Dotierstoff dotierten Pulver, der ein mit einem Dotierstoff dotiertes Pulver speichert.

9. Einkristallzüchtungsvorrichtung (10) nach einem der Ansprüche 3 bis 7, wobei der Trichter (40) ein Trichter für ein Pulvergemisch ist, der ein Pulvergemisch speichert, das durch Mischen eines Kristallbasismaterialpulvers und eines mit einem Dotierstoff dotierten Pulvers erhalten wird.

10. Einkristallzüchtungsvorrichtung (10) nach einem der Ansprüche 3 bis 7, wobei der Trichter (40) aufweist:
einen Trichter für Kristallbasismaterialpulver, der ein Kristallbasismaterialpulver speichert; und
einen Trichter für ein Pulvergemisch, der ein Pulvergemisch speichert, das durch Mischen des Kristallbasismaterialpulvers und eines mit einem Dotierstoff dotierten Pulvers erhalten wird.

11. Einkristallzüchtungsvorrichtung (10) nach einem der Ansprüche 1 bis 10, wobei die Pulverrohmaterialzufuhreinrichtung (14) dafür konfiguriert ist, das Pulverrohmaterial (24) innerhalb von 90% eines Durchmessers des Impfkristalls (30) zuzuführen.

12. Einkristallzüchtungsvorrichtung (10) nach einem der Ansprüche 1 bis 11, wobei die Infrarotlampe (20) eine Halogenlampe oder eine Xenonlampe ist.

13. Einkristallzüchtungsvorrichtung (10) nach einem der Ansprüche 1 bis 12, wobei mehrere Infrarotstrahlbestrahlungseinrichtungen (16) vorgesehen sind.

14. Einkristallzüchtungsvorrichtung (10) nach einem der Ansprüche 1 bis 13, wobei in einem unteren Teil des transparenten Quarzrohrs (12) ein Tisch (50) angeordnet ist, auf dem der Impfkristall (30) angeordnet ist.

15. Einkristallzüchtungsvorrichtung (10) nach Anspruch 14, wobei der Tisch eine Drehantriebsvorrichtung (52) aufweist.

16. Einkristallzüchtungsvorrichtung (10) nach Anspruch 14 oder 15, wobei der Tisch eine Hebeeinrichtung (54) aufweist, die sich mit einer vorgegebenen Geschwindigkeit in der vertikalen Richtung bewegt.

17. Einkristallzüchtungsvorrichtung (10) nach einem der Ansprüche 1 bis 16, mit einer Atmosphärensteuereinrichtung, die die Atmosphäre in dem transparenten Quarzrohr (12) evakuiert und/oder die Atmosphäre durch ein Inertgas ersetzt.

## Revendications

1. Dispositif de production de monocristal (10) comprenant au moins :
un tube en quartz transparent (12), dans lequel est placé un cristal d'ensemencement (30) ;
un appareil d'alimentation de substance brute en poudre (14) qui est agencé au-dessus dudit tube en quartz transparent (12) et alimente une substance brute en poudre (24) au niveau dudit cristal d'ensemencement (30) placé dans ledit tube en quartz transparent (12) ; et
un appareil d'irradiation par rayonnement infrarouge (16), qui est agence à l'extérieur dudit tube en quartz transparent (12) et qui applique un rayonnement infrarouge (18) sur la surface supérieure dudit cristal d'ensemencement (30) placé dans ledit tube en quartz transparent (12) ainsi que sur ladite substance brute en poudre alimentée dans ledit tube en quartz transparent (12) par ledit appareil d'alimentation de substance brute en poudre (14),
où ledit dispositif de production de monocristal (10) est conçu pour produire un monocristal (30a) en appliquant ledit rayonnement infrarouge (18) provenant dudit appareil d'irradiation par rayonnement infrarouge (16) dans ledit tube en quartz transparent (12) de sorte à faire fondre une surface supérieure dudit cristal d'ensemencement (30) et de ladite substance brute en poudre (24) et ensuite faire solidifier le produit de fusion résultant sur ledit cristal d'ensemencement (30), et
où ledit appareil d'irradiation par rayonnement infrarouge (16) est conçu pour appliquer ledit rayonnement infrarouge (18) sur jusqu'à 90 % du diamètre dudit cristal d'ensemencement (30),
où ledit appareil d'irradiation par rayonnement infrarouge (16) comprend :
un réflecteur elliptique (22) dont la surface intérieure est utilisée en tant que surface de réflexion ; et
une lampe infrarouge (20) qui est agencée au niveau d'une première position focale sur un côté inférieur dudit réflecteur elliptique (22),
ou dans lequel ledit appareil d'irradiation par rayonnement infrarouge (16) est un module laser à semi-conducteur qui applique un rayonnement laser dudit rayonnement infrarouge (18).

2. Dispositif de production de monocristal (10) selon la revendication 1, dans lequel un appareil de chauffage auxiliaire (32), qui chauffe une partie extérieure (60) dudit cristal d'ensemencement (30) est agencé.

3. Dispositif de production de monocristal (10) selon la revendication 1 ou la revendication 2, dans lequel ledit appareil d'alimentation de substance brute en poudre (14) comprend :
une trémie (40) qui stocke ladite substance brute en poudre (24) ;
une unité d'ajustement de l'alimentation (42) qui alimente une quantité prescrite de ladite substance brute en poudre (24) stockée dans ladite trémie au niveau d'une position prescrite dans ledit tube en quartz transparent (12) ; et
une conduite d'alimentation (44) qui est agencée sur une extrémité inférieure de ladite unité d'ajustement de l'alimentation (42) et par laquelle ladite substance brute en poudre (24) est alimentée dans ledit tube en quartz transparent (12).

4. Dispositif de production de monocristal (10) selon la revendication 3, dans lequel ladite unité d'ajustement de l'alimentation (42) comprend un appareil d'ajustement du rythme d'alimentation (34) qui ajuste un rythme auquel ladite substance brute en poudre (24) est alimentée dans ledit tube en quartz transparent (12).

5. Dispositif de production de monocristal (10) selon la revendication 3 ou la revendication 4, dans lequel l'unité d'ajustement de l'alimentation (42) comprend un appareil d'ajustement de la position d'alimentation (36) qui ajuste une position à laquelle ladite substance brute en poudre (24) est alimentée dans ledit tube en quartz transparent (12).

6. Dispositif de production de monocristal (10) selon l'une quelconque des revendications 3 à 5, dans lequel ladite trémie (40) est conçue de manière à ce qu'au récipient de substance brute en poudre (56), qui stocke ladite substance brute en poudre (24), y est fixé de manière amovible.

7. Dispositif de production de monocristal (10) selon l'une quelconque des revendications 3 à 6, dans lequel ladite conduite d'alimentation (44) est fabriquée en quartz.

8. Dispositif de production de monocristal (10) selon l'une quelconque des revendications 3 à 7, dans lequel ladite trémie (40) comprend :
une trémie pour de la poudre de substance de base de cristal, qui stocke une poudre de substance de base de cristal ; et
une trémie pour de la poudre dopée de dopant qui stocke une poudre dopée de dopant.

9. Dispositif de production de monocristal (10) selon l'une quelconque des revendications 3 à 7, dans lequel ladite trémie (40) est une trémie pour de la poudre mélangée, qui stocke une poudre mélangée obtenue en mélangeant une poudre de substance de base de cristal et une poudre dopée de dopant.

10. Dispositif de production de monocristal (10) selon l'une quelconque des revendications 3 à 7, dans lequel ladite trémie (40) comprend :
une trémie pour la poudre de substance de base de cristal qui stocke une poudre de substance de base de cristal ; et
une trémie pour de la poudre mélangée qui stocke une poudre mélangée obtenue en mélangeant ladite poudre de substance de base de cristal et une poudre dopée de dopant.

11. Dispositif de production de monocristal (10) selon l'une quelconque des revendications 1 à 10, dans lequel ledit appareil d'alimentation de substance brute en poudre (14) est conçu pour alimenter ladite substance brute en poudre (24) sur jusqu'à 90 % du diamètre dudit cristal d'ensemencement (30).

12. Dispositif de production de monocristal (10) selon l'une quelconque des revendications 1 à 11, dans lequel ladite lampe infrarouge (20) est une lampe à halogène ou une lampe au xénon.

13. Dispositif de production de monocristal (10) selon l'une quelconque des revendications 1 à 12, dans lequel une pluralité de dits appareils d'irradiation par rayonnement infrarouge (16) est agencée.

14. Dispositif de production de monocristal (10) selon l'une quelconque des revendications 1 à 13, dans lequel une table (50), sur laquelle ledit cristal d'ensemencement (30) est placé, est agencée dans une partie inférieure dudit tube en quartz transparent (12) .

15. Dispositif de production de monocristal (10) selon la revendication 14, dans lequel ladite table comprend un appareil à entrainement rotatif (52).

16. Dispositif de production de monocristal (10) selon la revendication 14 ou la revendication 15, dans lequel ladite table comprend un appareil élévateur (54) qui se déplace dans la direction verticale à une vitesse prescrite.

17. Dispositif de production de monocristal (10) selon l'une quelconque des revendications 1 à 16, comprenant un appareil de contrôle de l'atmosphère qui évacue par le vide l'atmosphère dans ledit tube en quartz transparent (12) et/ou remplace ladite atmosphère par un gaz inerte.
